# EUROPÄISCHE PATENTSCHRIFT

(11) **EP 2 074 238 B1**
(45) Veröffentlichungstag und Bekanntmachung des Hinweises auf die Patenterteilung: **31.07.2013**
(21) Anmeldenummer: 07818267.2
(22) Anmeldetag: 20.09.2007
(51) Int. Cl.: C23C 14/20, B60Q 3/04, G09F 13/08, H01H 9/18

(54) **KAPPE FÜR EIN ANZEIGE- ODER BEDIENELEMENT MIT LICHTDURCHLÄSSIGER METALLBESCHICHTUNG UND VERFAHREN ZU DEREN HERSTELLUNG**
CAP FOR A DISPLAY OR CONTROL ELEMENT, COMPRISING A LIGHT-PERMEABLE METAL COATING, AND METHOD FOR THE PRODUCTION THEREOF
CAPUCHON DESTINÉ À UN ÉLÉMENT D'AFFICHAGE OU DE COMMANDE ET MUNI D'UN REVÊTEMENT MÉTALLIQUE TRANSPARENT ET PROCÉDÉ POUR SA PRODUCTION

(30) Priorität: 22.09.2006 DE 102006045336; 22.06.2007 DE 102007029314
(43) Veröffentlichungstag der Anmeldung: 01.07.2009
(73) Patentinhaber: Preh GmbH, 97616 Bad Neustadt a. d. Saale (DE)
(72) Erfinder: LUST, Matthias, 74072 Heilbronn (DE); JEITNER, Martin, 97645 Ostheim (DE); KÜCHLER, Wolfgang, 97645 Ostheim (DE)
(74) Vertreter: Kayser, Martin
(86) Internationale Anmeldenummer: PCT/EP2007/008175
(87) Internationale Veröffentlichungsnummer: WO 2008/034611

(56) Entgegenhaltungen:
- EP-A- 1 217 491
- EP-A- 1 616 975
- DE-A1- 4 425 577
- DE-B3-102005 032 717
- US-B1- 6 168 242

## Beschreibung

Die Erfindung betrifft eine Kappe für ein Anzeige- oder Bedienelement, insbesondere eine Taste, zum Beispiel für die Verwendung in einem Kraftfahrzeug oder bei einem Haushaltsgerät. Die Kappe, die beispielsweise eine Tastenkappe ist, weist einen Kappenkörper und eine im Kappenkörper angeordnete Leucht- beziehungsweise Projektionsfläche auf, die bei bestimmungsgemäßen Gebrauch und Anordnung der Kappe als Teil eines Anzeige- oder Bedienelements für den Bediener aufgrund einer unter der Abdeckung angeordneten Lichtquelle sichtbar ist. Die Leucht- oder Projektionsfläche dient der Darstellung eines leuchtenden Symbols, das beispielsweise den Bediener darüber informiert, welche Vorrichtung mit dem Bedienelement bedienbar ist, beispielsweise die Klimasteuerung in einem Fahrzeug. Insbesondere kann die Leucht- oder Projektionsfläche dazu dienten, über den Schaltzustand des Bedienelements beziehungsweise den Schaltzustand der mit dem Bedienelement geschalteten Vorrichtungen zu informieren oder sie kann dazu dienen, über mit dem Anzeige- oder Bedienelement in Zusammenhang stehende Zustände, wie Such- oder Funktionsanzeigen, der Vorrichtungen zu informieren, um so beispielsweise eine Störung der mit dem Anzeige- oder Bedienelement verbundenen Vorrichtung anzuzeigen.

Die DE 10 2005 032 717 B3 beschreibt beispielsweise eine Bedieneinheit, die einen mit einer Oberflächenbeschichtung versehenen Kunststoffgrundkörper aufweist, wobei der Kunststoffgrundkörper einen ersten Bereich mit einer lichtundurchlässigen Oberflächenbeschichtung und einen zweiten Bereich mit einer lichtdurchlässigen Oberflächenbeschichtung aufweist und die lichtundurchlässige Oberflächenbeschichtung eine sichtbare metallische. Beschichtung enthält.

Aus der EP 1 217 491 A1 ist eine von ihrer Rückseite durchleuchtbare Bedientaste bekannt, die aus einem Grundkörper aus einem durchsichtigen Material besteht. Seine Rückseite wird mit einer lichtundurchlässigen Beschichtung versehen, die mittels Laserlicht erzeugte Durchbrechungen aufweist, die von einer, farbigen Schicht abgedeckt sind.

Aus der DE 10 2005 006 459 A1 ist bekannt, ein Anzeigeelement aus einem transparenten oder durchscheinenden Kunststoff in einem Teilbereich mittels einer haftvermittelnden Schicht mit einer Metallbeschichtung zu versehen, wobei die haftvermittelnde Schicht, die beispielsweise mittels PVD-Beschichtung (PVD = Physical Vapor Deposition) aufgebracht wurde, teilweise mittels Laser entfernt wurde, um bei Hinterleuchtung ein Symbol zu erzeugen. Die Metallbeschichtung ist opak.

Auch die DE 102 08 674 A1 beschreibt ein Verfahren zur Herstellung eines vorderseitig und zudem galvanisch beschichteten Bedien-, Dekor- oder Anzeigeelements, wobei ein transparenter oder durchscheinender Kunststoffkörper mit einer Metallschicht versehen wird, die partiell zur Erzeugung des Symbols abgetragen wird. Die Metallschicht wird nicht durchleuchtet. Zudem sind beide Verfahren vergleichsweise aufwendig. Ferner wirft die zum Betrachter beziehungsweise Bediener gewandte Metallschicht das Problem auf, dass sie vergleichsweise empfindlich gegenüber Reinigungsmitteln und Körperschweiß ist, so dass meist vorgeschlagen wird, einen zusätzlichen Schutzlack vorzusehen. Zu dem ist das Symbol bei den so hergestellten Bedien- oder Anzeigekappen meist auch bei Tageslicht, insbesondere bei direkter Sonnenlichteinwirkung, schon gut sichtbar, und damit ist für den Bediener bei dieser Beleuchtung nicht erkennbar, ob das Symbol tatsächlich leuchtet oder nicht, das heißt beispielsweise ob die mit dem Bedienelement geschaltete Vorrichtung eingeschaltet ist oder nicht oder ob eine Störung vorliegt oder nicht. Da somit bei nicht allen möglichen Lichtverhältnissen der Unterschied zwischen Such- und Funktionsbeleuchtungen gut zu erkennen ist, ist die Informationsübertragung nicht zuverlässig, da Fehlinformationen nicht bei allen Lichtverhältnissen vermieden werden können. Dies ist insbesondere bei einem Kraftfahrzeug aus sicherheitstechnischen Überlegungen bedenklich.

Aus der DE 103 37 456 A1 ist bekannt, ein Bauteil mit einer teillichtdurchlässigen Metallbeschichtung zur Erzeugung eines optischen Effekts zu versehen. Es handelt sich jedoch nicht um ein hinterleuchtetes Bedien- oder Anzeigeelement.

Es ist daher Aufgabe der vorliegenden Erfindung, eine Kappe, insbesondere eine Tastenkappe, für ein Bedienelement beziehungsweise ein zugehöriges Bedienelement bereitzustellen, bei dem die Darstellung des auf der Leucht- beziehungsweise Projektionsfläche wiedergegebenen Symbols im eingangs beschriebenen Sinne verbessert ist, das zudem preiswert herzustellen und haltbar ist. Diese Aufgabe wird durch eine Kappe gemäß Aspruch 1, beziehungsweise ein Anzeige- und/oder Bedienelement gemäß Anspruch 7 beziehungsweise 8 gelöst. Ein zugehöriges Herstellungsverfahren, sowie eine vorteilhafte Verwendung sind Gegenstand der nebengeordneten Ansprüche. Die Unteransprüche betreffen jeweils vorteilhafte Ausgestaltungen.

Die erfindungsgemäße Kappe ist für ein Anzeige- oder Bedienelement bestimmt und ist beispielsweise für die Abdeckung eines reinen Anzeigeelements vorgesehen oder dient der Abdeckung und Betätigung eines Schalters eines zugehöriges Bedienelements, das mit einer Anzeigevorrichtung kombiniert ist.

Somit bildet die Kappe beispielsweise wenigstens mit dem Schalter das zugehörige Bedienelement. Die Kappe ist beispielsweise in ein Bedien- oder Anzeigefeld oder ein Armaturenbrett eines Kraftfahrzeugs integriert. Beispielsweise handelt es sich bei dem zugehörigen Schalter um einen Tastschalter, Wippschaltär, Drucktaste, Drehschalter usw. Erfindungsgemäß ist in dem Kappenkörper eine Leucht- beziehungsweise Projektionsfläche vorgesehen, die so ausgestaltet ist, dass durch Bestrahlung durch eine schalterseitig beziehungsweise innenseitig angeordnete Lichtquelle ein auf der Leucht- beziehungsweise auf der Projektionsfläche dargestelltes Symbol, beispielsweise ein Schriftzeichen, ein Schriftzug oder ein Piktogramm, für einen Betrachter beziehungsweise Bediener des Anzeigebeziehungsweise Bedienelements, beispielsweise den Fahrer, sichtbar wird. Die erfindungsgemäße Kappe zeichnet sich dadurch aus, dass die Leucht- beziehungsweise Projektionsfläche eine lichtdurchlässige Metallbeschichtung umfasst. Der Grad der Lichtdurchlässigkeit und die auf der Innenseite der Kappe vorgesehene Lichtquelle beziehungsweise deren Lichtintensität und/oder deren Spektrum sind so gewählt, dass zwar das vergleichsweise intensive Licht der Lichtquelle durchgelassen wird und damit der Betrachter das beleuchtete Symbol gut erkennen kann, andererseits aber der Reflexionsgrad der Metallbeschichtung für eine ausreichende Reflexion des Umgebungslichts sorgt.

Bevorzugt wird die Metallbeschichtung mittels eines PVD (physical vapor deposition) Verfahrens aufgebracht. Bei den PVD-Verfahren unterscheidet man grundsätzlich zwischen zwei verschiedenen Verfahren. Einerseits gibt es die kostengünstigere Variante des Bedampfens, bei der durch die Zufuhr thermischer Einergie bei Niedrigtemperatur schmelzende Metalle verdampft und so auf die Oberfläche des Tastenkörpers aufgebracht werden. Dieses Verfahren wird beispielsweise bei der Bedampfung mit Aluminium oder Kupfer verwendet. Andererseits wird das Sputtern von Substratmaterial, wie beispielsweise Edelstahl, mit Hilfe eines ionisierten Prozessgases eingesetzt.

Dabei wird ein Prozessgas (meist Argon) ionisiert und mittels Magnetfeldunterstützung auf das abzuscheidende Material (Target) beschleunigt (Magnetronsputtern). Durch Impulsübertragung der ionisierten Gasatome werden im Vakuum Atome und Atomcluster aus dem Target herausgeschlagen und lagern sich an gewünschter Stelle auf der Oberfläche des Kappenkörpers ab. Derartige Verfahren sind in der DE 103 37 456 A1 beschrieben, deren Offenbarungsgehalt hierin durch Bezugnahme umfasst ist.

Bei Bedarf kann zur Steigerung der Haftfestigkeit eine Vorbehandlung oder Aktivierung des Kappenkörpers vorgenommen werden. Diese Haftsteigerung kann zum Beispiel notwendig sein, wenn die Metallbeschichtung auf der dem Bediener zugewandten Oberfläche des Kappenkörpers aufgebracht ist und von diesem regelmäßig beispielsweise zur Betätigung des zugehörigen Schalters berührt wird oder des Öfteren Kontakt mit vergleichsweise aggressiven Reinigungsflüssigkeiten hat. Mit diesen speziellen Verfahren zur Behandlung von Oberflachen, wie beispielsweise nasschemische Oberflächenvorbehandlungsverfahren, wie Beizen, und physikalische Oberflächenvorbehandlungsverfahren, wie Beflammung (Pyrolyse), Fluorierung, Coronabehandlung und Plasmaverfahren, wird die zu beschichtende Oberfläche vorbehandelt beziehungsweise aktiviert. Durch den Vorgang der Aktivierung wird deren Polarität beziehungsweise deren Oberflächenenergie erhöht, wodurch ein verbessertes Haftvermögen beziehungsweise eine verbesserte Benetzbarkeit erzielt wird.

Erfindungsgemäß ist die Metallbeschichtung nicht auf einer dem Bediener beziehungsweise dem Betrachter zugewandten Oberfläche des Kappenkörpers, sondern beispielsweise auf der, der Lichtquelle zugewandten, Innenoberfläche der Kappe wenigstens im Bereich der Leucht- beziehungsweise Projektionsfläche aufgebracht und befindet sich somit an einer durch den Kappenkörper verdecken Stelle. Da die Metallbeschichtung daher nicht von dem Bediener berührt werden kann und auch nicht in Kontakt mit Reinigungsflüssigkeiten gerät, ist die Metallbeschichtung nicht abriebgefährdet und es sind keine hohe Anforderungen an ihre chemische Beständigkeit zu stellen. Spezielle Öberflächenvorbehandlungsverfahren zur Steigerung der Haftfähigkeit können somit vorteilhaft entfallen.

Bei einer weiteren vorteilhaften Ausgestaltung weist die Metallbeschichtung bevorzugt eine Dicke von weniger als 5µm, bevorzugt im Bereich von 10 nm - 50 nm auf. Es hat sich überraschend gezeigt, dass insbesondere ein derartiger Bereich von 5 nm - 50 nm einerseits eine ausreichende Reflexion des Umgebunglichts bereitstellt, andererseits aber noch eine ausreichende Durchlässigkeit des Lichts bei gängigen Lichtquellen wie LEDs bereitgestellt werden kann, dass, das "Anzeigen" des betreffenden Symbols ausreichend gut zu erkennen ist.

Die Metallbeschichtung umfasst in einer vorteilhaften Ausgestaltung wenigstens eine Metallschicht aus wenigstens einem Metall oder Halbmetall wie Sc, Y, Ti, Zr, V, Nb, Ta, Cr, Mo, W, Mn, Fe, Co, Pd, Pt, Cu, Ag, Au, Zn, B, AI, In, TI, Si, Ge, In, Pb, Sb, Bi, Legierungen oder Mischschichten davon und/oder Edelstahl ausgewählt ist, aufweist. Die verschiedenen Metalle oder mehrere unterschiedliche Metallschichten können vorgesehen sein, um verschiedene optische Effekte, beispielweise farbige Reflexion, zu erzielen. Beispiele hierzu sind ebenfalls in der DE 103 37 456 A1 offenbart.

Erfindungsgemäß ist die Leuchtfläche mit einer das symbol wiedergebenden Maske versehen. Die Maske ist eine Blende mit einer Lichtdurchtassöffnung, derein Form der Gestalt des darzustellenden Symbols entspricht. Mit einer Maske kann die erfindungsgemäße Kappe besonders preiswert hergestellt werden. Durch Aufbringen der Maske unmittelbar auf die Leuchtfläche wird eine besonders scharf konturierte Darstellung des Symbols erreicht.

Bei einer weiteren vorteilhaften ausgestaltung wird die Maske mittels einer opaken Lackschicht, die abschnittsweise beispielsweise mittels Laserbearbeitung entfernt wird, erzeugt. Dadurch kann die erfindungsgemäße Kappe besonders preiswert hergestellt werden. Aufgrund der sehr flexiblen Bearbeitungsmöglichkeiten durch den Laser lassen sich beliebige Symbole auf der Kappe darstellen..

Erfindungsgemäß ist der Käppenkörper wenigstens im Bereich der Leucht- beziehungsweise Projektionsfläche, bevorzugt der gesamte Kappenkörper, transparent oder durchleuchtend ausgestaltet, ferner ist die Maske auf der dem Schalter zugewandten Innenseite der Kappe und daran angrenzend angeordnet und zwischen der Maske und der Lichtquelle ist die Metallbeschichtung aufgebracht. Durch diese Art der Anordnung lässt sich die erfindungsgemäße Kappe vergleichsweise preiswert herstellen. Der Kappenkörper beziehungsweise die Leucht- beziehungsweise Pröjektionsfläche kann eingefärbt sein, um dem dargestellten Symbol eine gewünschte Farbe zu verleihen. Die Farbe der opaken Lackschicht ist dabei bevorzugt auf die Reflexionswirkung der darunter angeordneten Metallbeschichtung abgestimmt, so dass bei ausgeschalteter Lichtquelle eine deutliche Ablesbarkeit des unbeleuchteten Symbols durch einen großen Unterschied in Reflexion und/oder Farbwirkung gewährleistet ist.

Erfindungsgemäß ist auf die Maske eine transparente oder durchscheinende Lackschicht aufgebracht und die Metallbeschichtung grenzt an die transparenten oder durchscheinende Lackschicht, an. Durch die transparente oder durchscheinende Lackschicht, das heißt durch deren Verteilen nach der Aufbringung und vor dem Aushärten, wird trotz der in der Maske in Symbolform vorgesehenen Öffnung(-en) beziehungsweise Vertiefung(-en) und der damit verbundenen Unebenheit(-en) eine vergleichsweise glatte Oberfläche erzeugt. Dies erleichtert das Aufbringen der Metallbeschichtung und damit die Herstellung der Kappe.

Die Erfindung betrifft ferner ein Bedienelement, das die zuvor beschriebene Appe in den zuvor beschriebenen Ausgestaltungen und mit den jeweils beschriebenen Vorteilen umfasst. Das Bedienelement ist beispielsweise ein Drehschalter. Bevorzugt handelt es sich bei dem Bedienelement um einen Tastschalter und bei der Bedienelementkappe entsprechend um eine Tastkappe.

Die Erfindung betrifft ferner ein Anzeigeelement, das die zuvor beschriebenen Kappe in den zuvor beschriebenen Ausgestaltungen und mit den jeweils beschriebenen Vorteilen umfasst.

Das zuvor beschriebene Bedienelement findet nicht zuletzt aufgrund der sehr stark variierenden Lichtverhältnisse besonders vorteilhafte Verwendung in einem Kraftfahrzeug, wo es beispielsweise in ein Armaturenbrett oder ein Bedienfeld integriert ist.

Die Erfindung betrifft ferner ein Verfahren zur Herstellung einer Bedienelementkappe in einer der zuvor beschriebenen Ausführungsformen. Dabei wird in einem ersten Schritt der transparente oder durchscheinende Kappenköper aus Polycarbonat, beispielsweise Lexan^{®}, in einem Spritzguss- oder Tiefziehverfahren hergestellt. In einem zweiten, nachfolgenden Schritt wird der mit dem Laser bearbeitbare, opake Lack auf der dem Schalter beziehungsweise der Lichtquelle des Anzeige- beziehungsweise Bedienelements zugewandten Innenseite des Kappenkörpers aufgebracht. In einem dritten, nachfolgenden Schritt wird der opake Lack zur Erzeugung der das Symbol wiedergebenden Maske mit dem Laser bearbeitet, um eine Maske zu erzeugen. Bis auf die Öffnung der Maske bleibt die Innenseite, das heißt der der Lichtquelle beziehungsweise dem Schalter zugewandten Seite des Kappenkörpers lichtdicht abgeschottet. In einem vierten Schritt wird die Maske mit einem transparenten oder durchscheinenden Lack überzogen, um die Fläche einzuebnen. In einem fünften Schritt wird die Metallbeschichtung in einem PVD-Verfahren auf den transparenten oder durchscheinenden Lack aufgebracht. In einem sechsten optionalen Schritt wird der Kappenkörper auf der dem Bediener zugewandten Seite mit einem transparenten Schutzlack überzogen.

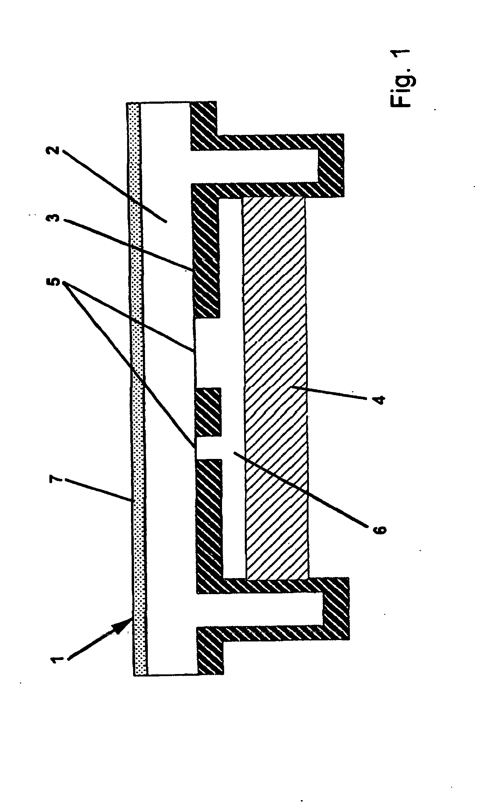

In der beigefügten Figur ist eine bevorzugte Ausführungsform der erfindungsgemäßen Bedienelementkappe dargestellt, ohne die Erfindung darauf zu beschränken, wobei
- Figur 1: eine schematische Seitenschnittansicht der erfindungsgemäßen Anzeigebeziehungsweise Bedienelementkappe zeigt. Da die Darstellung lediglich der Anschauung dient, handelt es sich nicht um eine maßstabsgetreue Darstellung.

Figur 1 zeigt eine erfindungsgemäße Anzeige- beziehungsweise Bedienelementkappe, die allgemein mit 1 bezeichnet ist. Die Kappe 1 umfasst einen transparenten oder durchscheinenden Kappenköper 2 aus Polycarbonat, beispielsweise Lexan^{®}, der in einem Spritzguss- oder Tiefziehverfahren hergestellt wird. Auf der dem Schalter beziehungsweise der Lichtquelle zugewandten Innenseite des Kappenkörpers 2 (die untere Seite des Kappenkörpers 2) ist ein opaker Lack 3 aufgebracht. Der Lack 3 wurde zur Erzeugung einer das Symbol 5 wiedergebenden Maske mit dem Laser bearbeitet. Die Unterseite des Lackes beziehungsweise der Maske 3 ist mit einem transparenten oder durchscheinenden Lack 6 überzogen, der die durch die Laserbearbeitung erzeugten Unebenheiten in dem opaken Lack 3 ausgleicht. Auf den Lack 6 ist eine Metallbeschichtung 4 mittels eines PVD-Verfahrens aufgebracht. Wie oben bereits ausgeführt, entspricht die dargestellte Dicke keinesfalls den tatsächlichen Verhältnissen. Der Kappenkörper 2 ist auf der dem Bediener zugewandten Seite mit einem transparenten, beispielsweise hochglänzenden, Schutzlack 7 überzogen. Im eingebauten Zustand, befindet sich unterhalb des Tastenkörpers 1 eine nicht dargestellte Lichtquelle. Licht dieser Lichtquelle durchdringt die lichtdurchlässige Metallbeschichtung 4 durchdringt den durchscheinenden oder transparenten Lack 6 und lässt aufgrund der durch den opaken Lack erzeugten Maske 3 das Symbol 5 leuchten. Dieses ist von der Bedienerseite her durch den transparenten Schutzlack 7 und den durchscheinenden oder transparenten Kappenkörper 2 sichtbar. Bei ausgeschalteter Lichtquelle tritt das Symbol 5 aufgrund der reflektierenden, metallischen Wirkung der Metallbeschichtung 4 gegenüber von der Seite des Bedieners einfallendem Licht gar nicht in Erscheinung.

Alternativ ist es möglich und erfindungsgemäß vorstellbar, die Maske 3 aus einer mittels eines Druckverfahrens, insbesondere mittels eines Tampon-DruckVerfahrens, aufgebrachten Lackschicht 3 auszubilden, so dass auf das Lasern verzichtet werden kann. Eine weitere Alternative ist das Einlegen einer mit einer Lackschicht 3 bedruckten Folie in den Kappenkörper 2, wobei die Folie ohne Luftspalt zwischen Lackschicht beziehungsweise Folie und Kappenkörper 2 in den Kappenkörper 2 einklebbar köder mit einem sehr geringen Luftspalt in den Kappenkörper 2 einlegbar ist. Auf die in den Kappenkörper 2 eingebrachte Folie ist anschließend die mittels des PVD-Verfahrens auftragbare Metallbeschichtung 4 aufbringbar. Zum Schutz der PVD Schicht ist diese alternativ mit einer Klarlackschicht schützbar.

## Patentansprüche

1. Kappe (1) für ein Anzeige- und/oder Bedienelement, umfassend einen Kappenkörper (2) zur Abdeckung einer Lichtquelle und/oder Betätigung eines Schalters eines zugehörigen Bedienelements, wobei in dem Kappenkörper (2) eine Leucht- beziehungsweise Projektionsfläche so ausgestaltet ist, dass durch Bestrahlung durch eine schalterseitig angeordnete Lichtquelle ein auf der oder durch die Leucht- beziehungsweise Projektionsfiache dargestelltes Symbol, (5) für einen Bediener des Bedienelements beleuchtbar ist, wobei die Leucht- beziehungsweise Projektionsfläche ein lichtdurchlässige, bevorzugt durch ein PVD-Verfahren aufgebracht, Metallbeschichtung (4) umfasst, der Kappenkörper (2) wenigstens im Bereich der Leuchtbeziehungsweise Projektionsfläche transparent oder durchleuchtend ausgestaltet ist und die Leuchtfläche mit einer das Symbol wiedergebenden Maske (3) versehen ist **dadurch gekennzeichnet, dass** die Maske (3) auf der dem Schalter zugewandten Innenseite des Kappenkörper (2) und daran angrenzend angeordnet ist, dass auf die Maske (3) eine transparente oder durchscheinende Lackschicht (6) aufgebracht ist und die Metallbeschichtung (4) auf die transparente oder durchscheinende Lackschicht (5) wenigstens im Bereich der Leucht- beziehungsweise Projektionsfläche aufgebracht ist.

2. Kappe (1) für ein Anzeige- und/oder Bedienelement nach Anspruch 1, **dadurch gekennzeichnet, dass** die Metallbeschichtung (4) auf eine Trägerfolie aufgebracht ist, wobei die Trägerfolie als Einlegeteil in die Kappe (1) eingebracht ist.

3. Kappe (1) für ein Anzeige- und/oder Bedienelemeöt nach einem der vorhergehenden Ansprüche, **dadurch gekennzeichnet, dass** die Metallbeschichtung (4) eine Dicke von weniger als 5 µm, bevorzugt im Bereich von 10 nm - 50 nm aufweist.

4. Kappe (1) für ein Anzeige- und/oder Bedienelement nach einem der vorhergehenden Ansprüche, **dadurch gekennzeichnet, dass** die Metallbeschichtung (4) wenigstens eine Metallschicht mit wenigstens einem Metall oder Halbmetall, das aus Sc, Y, Ti₁ Zr, V, Nb, Ta, Cr, Mo, W, Mn, Fe, Co, Pd, Pt, Cu, Ag, Au, Zn, B, AI, In, Tl, Si₁ Ge, Sn₁ Pb₁ Sb, Bi₁ Legierungen oder Mischschichten davon und/oder Edelstahl ausgewählt ist, aufweist.

5. Kappe (1) für ein Anzeige- und/oder Bedienelement nach dem vorhergehenden Anspruch, **dadurch gekennzeichnet, dass** die Maske (3) mittels einer opaken, insbesondere schwarzen, Lackschicht, die abschnittsweise beispielsweise mittels Laserbearbeitung entfernt wird, erzeugt ist.

6. Kappe (1) für ein Anzeige- und/oder Bedienelement nach einem der vorhergehenden Ansprüche, **dadurch gekennzeichnet, dass** die Maske (3) durch eine bereichsweise Bedruckung mit einer opaken Beschichtung realisiert ist.

7. Anzeige- und/oder Bedienelement **gekennzeichnet durch** eine Bedienelementkappe (1) nach einem der vorhergehenden Ansprüche.

8. Bedienelement nach dem vorhergehenden Anspruch, **dadurch gekennzeichnet, dass** das Bedienelement ein Tastschalter ist und die Bedienetementkappe eine Tastkappe (1) ist.

9. Verwendung des Anzeige- und/oder Bedienelements nach einem der beiden vorhergehenden Ansprüche in einem Kraftfahrzeug.

10. Verfahren zur Herstellung einer Kappe (1) für ein Anzeige- und/oder Bedienelement nach einem der Ansprüche 1 bis 8, wobei in einem ersten Schritt der transparente oder durchscheinende Kappenkörper (2) aus Polycarbonat, beispielsweise Lexan^{(R)}, in einem Spritzguss- oder Tiefziehverfahren hergestellt wird; in einem zweiten Schritt der Lack (3) auf der der Lichtquelle zugewandten Innenseite des Kappenkörpers (2) aufgebracht wird, in einem dritten Schritt der opake Lack (3) zur Erzeugung der das Symbol (5) wiedergebenden Maske mit dem Laser entfernt wird, in einem vierten Schritt der Lack beziehungsweise die Maske (3) mit einem transparenten oder durchscheinenden Lack (6) überzogen wird, und in einem fünften Schritt die Metällbeschichtung (4) auf den transparenten oder durchscheinenden Lack mittels eines PVD-Verfahrens aufgebracht wird und in einem sechsten optionalen Schritt der Kappenkörper auf der dem Bediener zugewandten Seite mit einem transparenten Schutzlack (7) überzogen wird.

11. Verfahren zur Herstellung einer Kappe (1) für ein Anzeige- und/oder Bedienelement nach Anspruch 10, **dadurch gekennzeichnet, dass** eine transparente Lackschicht auf die Metallbeschichtung (4), auf der dem Bedienteil zugewandten Seite, aufgebracht Wird.

12. Verfahren zur Herstellung einer Kappe (1) für ein Anzeige- und/oder Bedienelement nach Anspruch 10 oder 11, **dadurch gekennzeichnet, dass** die Maske (3) mittels eines Druckverfahrens auf den Kappenkörper (2) aufgebracht wird.

## Claims

1. A cap (1) for a display and/or control element, comprising a cap member (2) for covering a light source and/or for actuating a switch of an associated control element, wherein a luminous or projection area in the cap member (2) is configured such that a symbol (5) represented on or through the luminous or projection area becomes visible for an operator of the control element as a result of illumination by a light source located on the switch side, wherein the luminous or projection area comprises a light-transmissive metal coating (4) preferably deposited by a PVD method, wherein the cap member (2) is configured to be transparent or translucent at least in the region of the luminous or projection area, and wherein the luminous area is provided with a mask (3) reproducing the symbol, **characterised in that** the mask (3) is disposed on the inner side of the cap member (2) facing the switch and adjacent thereto, that a transparent or translucent paint layer (6) is deposited on the mask (3) and the metal coating (4) is deposited on the transparent or translucent paint layer (6), at least in the region of the luminous or projection area.

2. The cap (1) for a display and/or control element according to claim 1, **characterised in that** the metal coating (4) is deposited on a carrier film, wherein the carrier film is introduced into the cap (1) as an insert.

3. The cap (1) for a display and/or control element according to any one of the preceding claims, **characterised in that** the metal coating (4) has a thickness of less than 5 µm, preferably in the range of 10 nm - 50 nm.

4. The cap (1) for a display and/or control element according to any one of the preceding claims, **characterised in that** the metal coating (4) comprises at least one metal layer with at least one metal or semimetal, such as Sc, Y, Ti, Zr, V, Nb, Ta, Cr, Mo, W, Mn, Fe, Co, Pd, Pt, Cu, Ag, Au, Zn, B, Al, In, Tl, Si, Ge, Sn, Pub, Sb, Bi, alloys or mixed layers thereof, and/or stainless steel.

5. The cap (1) for a display and/or control element according to the preceding claim, **characterised in that** the mask (3) is produced by means of an opaque, in particular black, paint layer that is removed in sections, for example by laser processing.

6. The cap (1) for a display and/or control element according to any one of the preceding claims, **characterised in that** the mask (3) is realized by sectional printing with an opaque coating.

7. A display and/or control element, **characterised by** a control element cap (1) according to any one of the preceding claims.

8. A control element according to the preceding claim, **characterised in that** the control element is a push-button and the control element cap is a push-button cap (1).

9. Use of the display and/or control element according to any one of the two preceding claims in a motor vehicle.

10. A method for producing a cap (1) for a display and/or control element according to any one of the claim 1 to 8, wherein, in a first step, the transparent or translucent cap member (2) is produced from polycarbonate, for example Lexan®, in an injection moulding or deep drawing process; in a second step, the paint (3) is deposited on the inner side of the cap member (2) facing the light source; in a third step, the opaque paint (3) is removed with the laser to produce the mask reproducing the symbol (5), in a fourth step, the paint or mask (3) is coated with a transparent or translucent paint (6), and in a fifth step, the metal coating (4) is deposited by means of a PVD method on the transparent or translucent paint, and in an optional sixth step, the cap member is coated with a transparent protective paint (7) on the side facing the operator.

11. The method for producing a cap (1) for a display and/or control element according to claim 10, **characterised in that** a transparent paint layer is deposited on the metal coating (4), on the side facing the control member.

12. The method for producing a cap (1) for a display and/or control element according to claim 10 or 11, **characterised in that** the mask (3) is deposited on the cap member (2) by means of a printing method.

## Revendications

1. Capuchon (1) pour un élément d'affichage et/ou de commande, comprenant un corps de capuchon (2) pour recouvrir une source de lumière et/ou pour commander un interrupteur d'un élément de commande associé, dans ledit corps de capuchon (2) étant réalisée une surface lumineuse ou bien de projection de telle manière que, par l'éclairage par une source de lumière disposée du côté de l'interrupteur, un symbole (5) représenté sur ou par ladite surface lumineuse ou bien de projection peut être illuminé pour un opérateur de l'élément de commande, ladite surface lumineuse ou bien de projection comprenant un revêtement métallique (4) transparent appliqué de préférence par un procédé PVD, ledit corps de capuchon (2) étant réalisé, au moins au niveau de ladite surface lumineuse ou bien de projection, de manière à être transparent ou translucide, et ladite surface lumineuse étant pourvue d'un masque (3) reproduisant le symbole, **caractérisé par le fait que** ledit masque (3) est disposé sur la face intérieure du corps de capuchon (2) qui est tournée vers ledit interrupteur et de manière contiguë à celle-ci, qu'une couche de vernis (6) transparente ou translucide est appliquée sur ledit masque (3) et que ledit revêtement métallique (4) est appliqué sur ladite couche de vernis (6) transparente ou translucide, au moins au niveau de ladite surface lumineuse ou bien de projection.

2. Capuchon (1) pour un élément d'affichage et/ou de commande, selon la revendication 1, **caractérisé par le fait que** ledit revêtement métallique (4) est appliqué sur une feuille de support, ladite feuille de support étant insérée comme pièce d'insertion dans ledit capuchon (1).

3. Capuchon (1) pour un élément d'affichage et/ou de commande, selon l'une quelconque des revendications précédentes, **caractérisé par le fait que** ledit revêtement métallique (4) présente une épaisseur inférieure à 5 µm, de préférence comprise entre 10 nm et 50 nm.

4. Capuchon (1) pour un élément d'affichage et/ou de commande, selon l'une quelconque des revendications précédentes, **caractérisé par le fait que** ledit revêtement métallique (4) présente au moins une couche métallique ayant au moins un métal ou semi-métal qui est choisi parmi Sc, Y, Ti, Zr, V, Nb, Ta, Cr, Mo, W, Mn, Fe, Co, Pd, Pt, Cu, Ag, Au, Zn, B, Al, In, TI, Si, Ge, Sn, Pb, Sb, Bi, les alliages ou couches mixtes de ceux-ci et/ou l'acier fin.

5. Capuchon (1) pour un élément d'affichage et/ou de commande, selon la revendication précédente, **caractérisé par le fait que** ledit masque (3) est produit au moyen d'une couche de vernis opaque, en particulier noire, qui est enlevée par sections par le biais d'un usinage au laser par exemple.

6. Capuchon (1) pour un élément d'affichage et/ou de commande, selon l'une quelconque des revendications précédentes, **caractérisé par le fait que** ledit masque (3) est réalisé en imprimant par zones un revêtement opaque.

7. Elément d'affichage et/ou de commande, **caractérisé par** un capuchon d'élément de commande (1) selon l'une quelconque des revendications précédentes.

8. Elément de commande selon la revendication précédente, **caractérisé par le fait que** ledit élément de commande est une touche à effleurement et que ledit capuchon d'élément de commande est un capuchon de touche (1).

9. Utilisation de l'élément d'affichage et/ou de commande selon l'une quelconque des deux revendications précédentes, dans un véhicule automobile.

10. Procédé de fabrication d'un capuchon (1) pour un élément d'affichage et/ou de commande, selon l'une quelconque des revendications 1 à 8, dans lequel, dans une première étape, ledit corps de capuchon (2) transparent ou translucide est réalisé à partir de polycarbonate, par exemple de Lexan^{®}, dans un procédé de moulage par injection ou d'emboutissage ; dans une deuxième étape, le vernis (3) est appliqué sur la face intérieure du corps de capuchon (2) qui est tournée vers ladite source de lumière ; dans une troisième étape, le vernis (3) opaque est enlevé au laser pour produire le masque reproduisant ledit symbole (5) ; dans une quatrième étape, ledit vernis ou bien le masque (3) est revêtu d'un vernis (6) transparent ou translucide, et, dans une cinquième étape, le revêtement métallique (4) est appliqué par un procédé PVD sur le vernis transparent ou translucide, et, dans une sixième étape optionnelle, le corps de capuchon est revêtu, sur la face montrant vers l'opérateur, d'un vernis protecteur transparent (7).

11. Procédé de fabrication d'un capuchon (1) pour un élément d'affichage et/ou de commande, selon la revendication 10, **caractérisé par le fait qu'**une couche de vernis transparente est appliquée sur ledit revêtement métallique (4), sur la face montrant vers la partie de commande.

12. Procédé de fabrication d'un capuchon (1) pour un élément d'affichage et/ou de commande, selon la revendication 10 ou 11, **caractérisé par** fait que ledit masque (3) est appliqué au moyen d'un procédé d'impression sur ledit corps de capuchon (2).
